# EUROPEAN PATENT APPLICATION

(11) **EP 2 474 770 A1**
(43) Date of publication of application: **11.07.2012**
(21) Application number: 11150623.4
(22) Date of filing: 11.01.2011
(51) Int. Cl.: F16L 55/28, G01N 27/90, H05K 9/00

(54) **Apparatus for pipeline inspection**

(71) Applicant: PII Limited, Northumberland NE23 1WW (GB)
(72) Inventor: Harvey, Raymond, Cramlington Northumberland NE23 1WW (GB); Fussell, Leon, Cramlington Northumberland NE23 1WW (GB); Rennison, Nigel, Cramlington Northumberland NE23 1WW (GB)
(74) Representative: McWilliams, David John

(57) **Abstract**

A sensor assembly (10) includes a sensor arm (14) having a sensor (24) is mounted at one end. The other end of the sensor arm (14) is pivotably support on a ring (18) which is carried on an in-line inspection tool (12). The assembly (10) includes sensor electronics (32) mounted on the ring in wired communication with the sensor (24). The sensor electronics (32) is held in place on the support structure by a clamping plate (36) produced from a non-conductive material having a conductive coating, and provides a conductive path across the sensor electronics (32). A metallic discharge strip (34) is provided between the clamping plate (36) and the sensor electronics (32), to act as a back up discharge path to the ring. The clamping plate (36) and sensor arm (14) can be made from plastics material, e.g. by injection moulding Nylon 12 material, to reduce the mass of the assembly.

## Description

The disclosure relates to apparatus for pipeline inspection, more particularly, to apparatus for in-line inspection of a fluid pipeline (e.g. on oil or gas pipeline).

It is known to inspect the inside of a pipeline using an inspection apparatus commonly referred to as a pipeline "pig". A known pig is provided with a magnet arrangement for generating a magnetic field adjacent the internal wall of a pipe along which the pig is travelling. The pig is further provided with a sensor assembly, which includes a radial array of sensor arms with a sensor mounted at the end of each arm and sensor electronics for receiving data from the sensors as the pig travels along the pipeline. In use, the sensors are biased into contact with the inner wall of a pipeline along which the pig is travelling, and detect changes in magnetic flux density in the magnetic field adjacent the pipe wall, in order to carry out an inspection of the pipe wall.

The sensor assembly is typically mounted on a ring or other support structure on the pig. However, the weight of the assembly can lead to sag in the support structure, which can have a negative effect on the data performance of the pig. As such it is desirable that the sensor assembly is as light as possible.

Static charge can build up during pipeline inspection. e.g. due to frictional contact between the pig and the inner wall of the pipeline. The sensor electronics must be protected from electrostatic discharge. Hence, it is desirable for parts of the pig to be equipotentially bonded to one another so that the static charge is evenly distributed throughout the pig. However, this leads to problems when attempting to replace conventional steel or aluminium components of the sensor assembly with more lightweight, non-conductive materials.

The disclosure overcomes or mitigates the above-discussed problems, or other disadvantages or problems, associated with known inspection apparatus.

The disclosure provides apparatus for pipeline inspection comprising a sensor assembly for inspecting the internal surface of a pipeline and a support structure for mounting the sensor assembly on a pipeline inspection tool, wherein the sensor assembly comprises a sensor arm having a first end and a second end, the first end of the arm is pivotably mounted on the support structure and the second end of the arm is biased towards an extended position relative to the support structure, and a sensor is mounted at the second of the sensor arm; the assembly further comprising sensor electronics mounted on the support structure and arranged in wired communication with the sensor for receiving signals from the sensor, wherein the sensor electronics is held in place on the support structure by a clamping plate and the clamping plate is produced from a non-conductive material having a conductive coating.

The accompanying drawings, which are incorporated in and constitute a part of the specification, illustrate one or more embodiments and, together with the description, explain these embodiments. In the drawings:
FIGURE 1 is a schematic cross-sectional view through a pipeline apparatus showing an exemplary embodiment of a sensor arm assembly;
FIGURE 2 is a schematic perspective view of an electronics potting assembly for use in the embodiment of Figure 1;
FIGURE 3 is a schematic perspective view of a protection strip for use in the embodiment of Figure 1;
FIGURE 4 is a schematic perspective view of a clamping plate for use in the embodiment of Figure 1
FIGURE 5 is a schematic cross-sectional view through the electronics potting assembly of Figure 2; and
FIGURE 6 is a schematic side view of an electronics assembly for use in the embodiment of Figure 1.

The following description of the exemplary embodiments refers to the accompanying drawings. The same reference numbers in different drawings identify the same or similar elements. The following detailed description does not limit the invention. Instead, the scope of the invention is defined by the appended claims.

Reference throughout the disclosure to "an exemplary embodiment," "an embodiment," or variations thereof means that a particular feature, structure, or characteristic described in connection with an embodiment is included in at least one embodiment of the subject matter disclosed. Thus, the appearance of the phrases "in an exemplary embodiment," "in an embodiment," or variations thereof in various places throughout the disclosure is not necessarily referring to the same embodiment. Further, the particular features, structures or characteristics may be combined in any suitable manner in one or more embodiments.

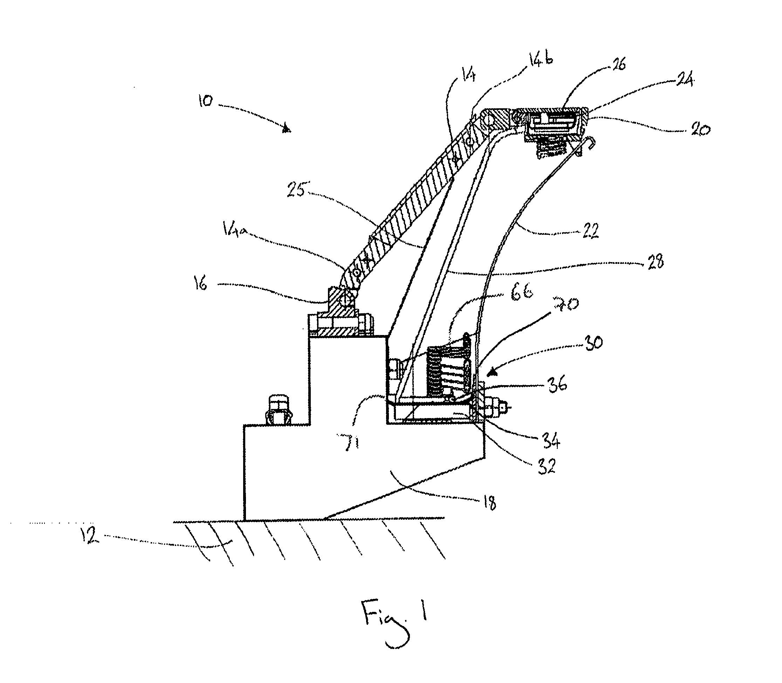

Referring firstly to Figure 1, an apparatus for pipeline inspection is indicated generally at 10. The apparatus 10 is in the form of a sensor assembly mounted on an inspection tool or "pig" (only part of which is indicated at 12) configured for in-line inspection of pipelines (e.g. oil or gas pipelines). The tool 104 includes a magnet arrangement (not shown) for generating a magnetic field adjacent the wall of a pipeline along which the tool is travelling. In general terms, the sensor assembly 10 is configured for detect changes in the magnetic flux density of the magnetic field, which may be indicative of corrosion and/or other defects in the material of the pipeline.

The sensor assembly 10 has a sensor arm 14 having a first end 14a and a second end 14b. The sensor arm 14 is pivotably mounted at its first end 14a on a base block 16. The base block 16 is mounted on a ring 18 which acts as a support structure for the sensor assembly 10 to be carried on the tool 12. In exemplary embodiments, the ring 18 is of conductive construction (e.g. produced from metal such as aluminium).

A sensor head 20 is pivotably attached to the second end 14b of the sensor arm 14. A spring 22 is connected between the ring 18 and the sensor head 20. The spring 22 serves to bias the head 20 towards an extended position, e.g. as shown in Figure 1. A magnetic flux leakage (MFL) sensor 24 is fitted in the sensor head 20, for detecting changes in magnetic flux density as the tool 12 travels long a pipeline.

A spring 25 (e.g. a torsion spring) serves to bias the arm 14 towards an extended position, for ensuring spring-loaded contact between the sensor head 20 and an internal surface of a pipe along which the inspection tool 12 is travelling. A wear strip 26 is provided on the sensor head 20.

A cable 28 connects the sensor 24 to an electronics assembly indicated generally at 30. The electronics assembly 30 includes an electronics unit 32, a discharge strip 34 and a clamp plate 36. A cable guide in the form of a spring 66 is provided on the assembly 30, for guiding the cable 28 during movement of the sensor arm 14, e.g. when the sensor arm 14 pivots clockwise from the position as viewed in Figure 1, in the event of a weld bead strike or other change in internal diameter of the pipeline along which the tool 104 is travelling.

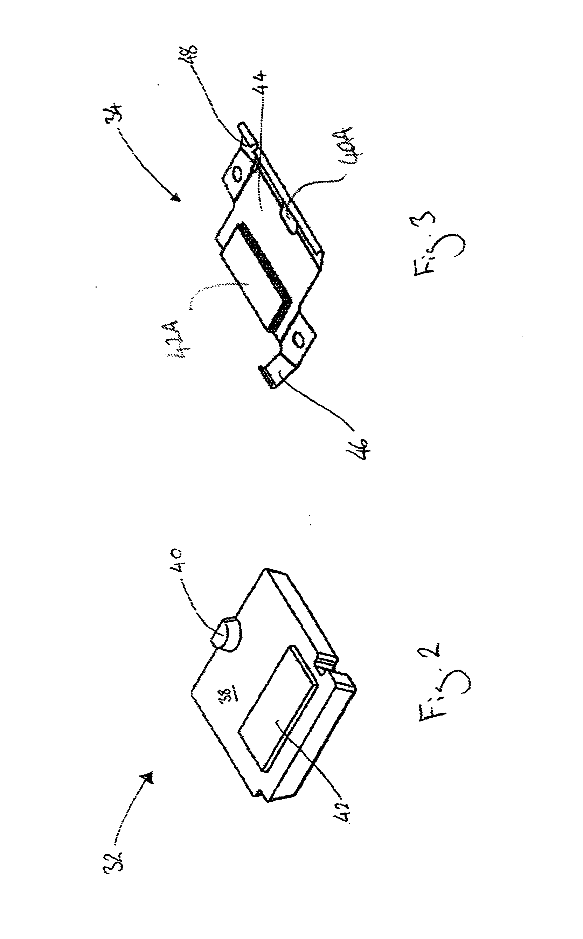

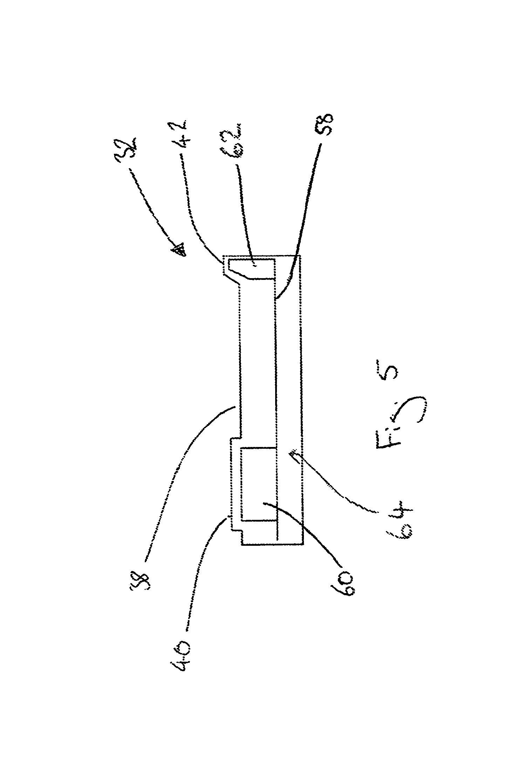

The electronics unit 32 is shown in more detail in Figures 2 and 5. The unit 32 consists of a printed circuit board (PCB) 58 including circuit components, examples of which are indicated at 60 and 62. The PCB 58 receives signals from the sensor 24 via the cable 28. The circuit board 58 and circuit components 60, 62 are potted in a potting compound 64. The potting compound 64 defines the unit 32 as a block of material having an upper face 38. The upper face 38 follows the profile of the PCB 58, so as to define projections 40, 42 over the PCB components 60, 62, and thereby reduce the overall material content of the block (thereby minimising weight of the unit 32).

The discharge strip 34 is shown in more detail in Figure 3. The strip 34 defines a main body 44 having a profile which corresponds to the profile of the upper surface 38 of the unit 32, e.g. for mating with the unit 32. Hence, in this embodiment, the main body 44 includes raised regions 40A, 42A, to accommodate the projections 40, 42 on the upper face 38 of the unit 32.

The discharge strip 34 further includes two pre-loaded arms 46, 48, which project from opposite sides of the main body 44. One of the arms 46 is arranged in contact with a conductive part 70 (see Figure 1) integral or connected to the ring 18, whilst the other arm 48 is arranged in contact with another conductive part 71 of the ring 18 on the other side of the unit 32.

Although not visible in the Figures, the strip 34 in this exemplary embodiment is constructed from two pre-formed sheets of metallic material, e.g. stainless steel, which are spot welded to one another, for ease of manufacturing. However, the disclosure broadly encompasses exemplary embodiments in which the strip 34 is of single sheet construction. In order to reduce the mass of the strip, it is advantageous to use thin material, such as 0.18mm Stainless Steel.

The strip 34 provides at least two points of conductive contact with the ring 18. The strip 34 provides an electrostatic discharge path across the unit 32 and electrical continuity to the ring 18. The disclosure broadly encompasses exemplary embodiments in which the strip 34 has only a single point of conductive contact to the ring 18. However, the use of multiple contact points is advantageous, e.g. in terms of secure construction and safety factor.

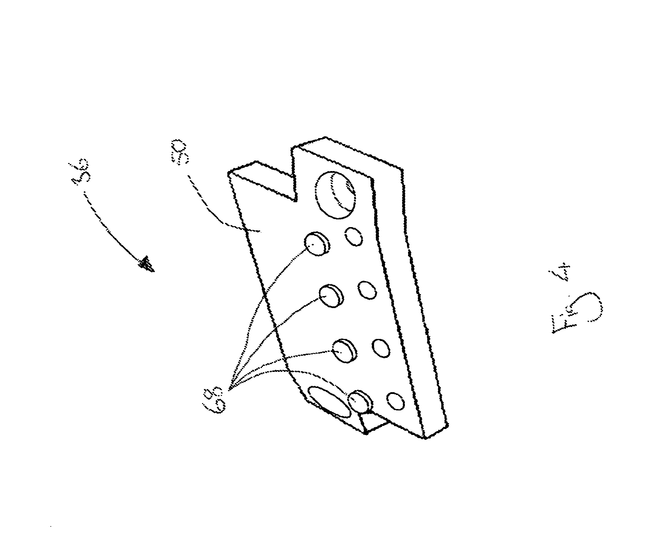

The clamping plate 36 is shown in more detail in Figure 4. The plate 36 consists of a main body 50. In this embodiment the main body is formed from lightweight plastics material such as Nylon 12 material, e.g. by injection moulding. Nylon 12 offers advantageous resistance to pipeline operating environments. Furthermore, the plate 36 is coated on all sides with a highly conductive electromagnetic shield coating, e.g. as produced by Trimite Global Coatings of Uxbridge, UK under part number J2904.

As will be described in more detail below, the plate 36 is used to clamp the unit 32 and discharge strip 34 in place on the ring 18. The coated plate 36 provides a lightweight clamp for the sensor electronics, whilst providing a primary discharge path to the ring 18, e.g. to protect the sensor electronics against electrostatic discharge.

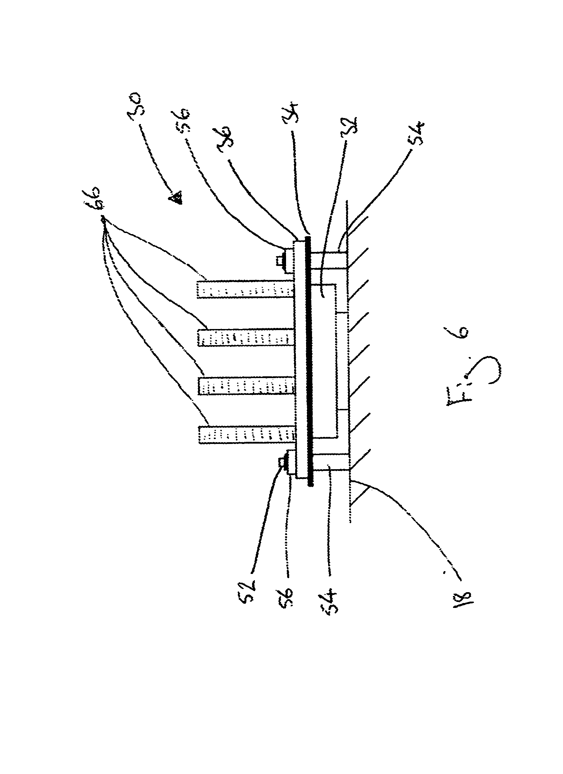

An exemplary arrangement is shown in Figure 6, wherein the plate 36 is mounted on studs 52 projecting up from the ring 18. The unit 32 and discharge strip 34 are arranged below the plate 36, and the plate 36 is held in place on the studs by locking nuts 56. A spacer 54 is provided around each stud 52, providing correct alignment of the plate 36 on the ring 18. Hence, the plate 36 is connected to the ring 18 by at least two points of conductive contact (e.g. via the studs) on either side of the unit 32. The use of multiple contact points is advantageous, e.g. in terms of secure construction and safety factor. However, the disclosure broadly encompasses exemplary embodiments in which the plate 36 has only a single point of conductive contact to the ring 18.

The plate 36 defines a bridge across the unit 32. The highly conductive nature of the electromagnetic shield coating enables the non-conductive plate to provide effective shielding for the circuitry in the electronics unit 32 against radiated electromagnetic interference, as well as protection against electrostatic discharge. Hence, conventional stainless steel clamping plates can therefore be replaced with lightweight clamping plates (e.g. of nylon or nylon 12 construction), advantageously reducing the mass of the sensor assembly without leading to loss of protection for the sensor electronics.

The thin discharge strip 34 provides back-up protection, e.g. in case the coating on the plate 36 becomes damaged, without significantly adding to the mass of the assembly 10.

In exemplary embodiments, the sensor arm is produced from plastics material, such as nylon (e.g. Nylon 12), by injection moulding, advantageously reducing the mass of the sensor assembly 10, as well as reducing manufacturing costs and lead time. In such embodiments, the sensor head and/or pivot block may also be formed from the same or similar plastics material as the sensor arms, to further reduce the mass, manufacturing costs and lead time. The use of a lightweight conductive coated clamp plate 36 and back up metallic discharge strip 34 above the electronics unit 32 on the ring 18 is particularly suited to sensor assemblies which incorporate such lightweight sensor arm assemblies.

Although not illustrated, it will be understood that the ring 18 supports a radial array of sensor assemblies 10 on the tool 104, e.g. of the kind shown in Figure 1. In the exemplary embodiment of Figure 6, the arrangement is configured for use with four sensors, such that four separate cables connect to the PCB 58 in the unit 32. To that end, four separate cable guides 66 are mounted on the plate 36.

Accordingly, the plate 36 shown in Figure 4 includes four circular projections 68 extending upwardly in a row from the main body 50. The projections 68 each locate a respective cable spring 66, as shown in Figure 6.

In exemplary embodiments, other nylon components of the tool may be coated with electromagnetic shield coating, e.g. the sensor arm, sensor head and/or pivot block, in order to provide enhanced electrical continuity and protection against radiated emissions.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial difference from the literal languages of the claims.

## Claims

1. Apparatus for pipeline inspection comprising a sensor assembly for inspecting the internal surface of a pipeline and a support structure for mounting the sensor assembly on a pipeline inspection tool, wherein the sensor assembly comprises a sensor arm having a first end and a second end, the first end of the arm is pivotably mounted on the support structure and the second end of the arm is biased towards an extended position relative to the support structure, and a sensor is mounted at the second of the sensor arm; the assembly further comprising sensor electronics mounted on the support structure and arranged in wired communication with the sensor for receiving signals from the sensor, wherein the sensor electronics is held in place on the support structure by a clamping plate and the clamping plate is produced from a non-conductive material having a conductive coating.

2. Apparatus according to claim 1 wherein the clamping plate acts as a conductive shield for the sensor electronics and defines a conductive path to a point of conductive contact on the support structure.

3. Apparatus according to claim 2 wherein the conductive path comprises a bridge over the sensor electronics.

4. Apparatus according to claim 1, further including a conductive discharge strip between the clamping plate and the sensor electronics, wherein the discharge strip provides a back up electrostatic discharge path to the support structure across the sensor electronics.

5. Apparatus according to claim 4 wherein the discharge strip comprises sheet metallic material.

6. Apparatus according to claim 4 wherein the discharge strip comprises pre-loaded arms arranged for contact with separate points on the support structure across the sensor electronics.

7. Apparatus according to claim 4 wherein the sensor electronics comprises a potted circuit board unit having an upper profile which follows the profile of the circuit board, and wherein the discharge strip defines a profile configured to mate onto the upper profile of the potted circuit board unit.

8. Apparatus according to claim 1 wherein the clamping plate is an injection moulded component.

9. Apparatus according to claim 1 wherein the clamping plate is made from plastics material.

10. Apparatus according to claim 9 wherein the clamping plate is made from Nylon 12.

11. Apparatus according to claim 1 wherein the conductive coating is an electromagnetic shield coating.

12. Apparatus according to claim 1 wherein the sensor arm is of plastics construction.

13. Apparatus according to claim 12 wherein the coated clamp plate provides a primary discharge path to the support structure.

14. Apparatus according to claim 12 wherein the sensor arm is of injection moulded construction.

15. Apparatus according to claim 12 wherein the sensor arm is made from nylon material.
